(19) Europäisches Patentamt / European Patent Office / Office européen des brevets

(11) **EP 2 431 404 A1**

(12) **EUROPÄISCHE PATENTANMELDUNG**

(43) Veröffentlichungstag:
**21.03.2012 Patentblatt 2012/12**

(21) Anmeldenummer: **10174424.1**

(22) Anmeldetag: **27.08.2010**

(51) Int Cl.:
*C08J 3/09* (2006.01)　　*C08J 3/11* (2006.01)
*C08J 3/215* (2006.01)　*H01L 37/02* (2006.01)
*H01L 41/22* (2006.01)　*H01L 41/26* (2006.01)

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**
Benannte Erstreckungsstaaten:
**BA ME RS**

(71) Anmelder:
• **Fraunhofer-Gesellschaft zur Förderung der angewandten Forschung e.V.**
**80686 München (DE)**
• **Joanneum Research Forschungsgesellschaft mbH**
**8010 Graz (AT)**

(72) Erfinder:
• **Bauer, Siegfried**
**4040 Linz (AT)**

• **Krause, Markus**
**4203 Altenberg (AT)**
• **Helbig, Uta**
**90403 Nürnberg (DE)**
• **Domann, Gerhard**
**97204 Höchberg (DE)**
• **Stadlober, Barbara**
**8044 Graz (AT)**
• **Zirkl, Martin**
**8071 Dörfla (AT)**

(74) Vertreter: **Olgemöller, Luitgard Maria et al**
**Patentanwältin**
**Lindenstraße 12a**
**81545 München (DE)**

(54) **Fluorpolymerhaltige Lösung oder Suspension, Verfahren zu ihrer Herstellung sowie ihre Verwendung bei der Herstellung von piezo- und pyroelektrischen Schichten**

(57)　Die vorliegende Erfindung betrifft ein Verfahren zum Herstellen einer homogenen Lösung eines Fluorpolymeren, ausgewählt unter Fluor-Homo- und Copolymeren und Gemischen verschiedener Fluor-Homo- und/oder Copolymere, in einem hochsiedenden Lösungsmittel, worin

(a) das zu lösende Fluorpolymer in einer Mischung aus mindestens zwei Lösungsmitteln gelöst wird, dessen erstes einen Siedepunkt von unter 150°C, und/oder einen Dampfdruck von über 5 hPa (bei 20°C) aufweist und dessen zweites ein hochsiedendes Lösungsmittel ist, das einen um mindesten 50°K höheren Siedepunkt aufweist als das erste Lösungsmittel und/oder dessen Siedepunkt so gewählt ist, dass die Lösungsmittel-Mischung einen Trennfaktor $\alpha$ von $\geq 1$, aufweist, und anschließend

(b) das erste Lösungsmittel aus dem Gemisch im Wesentlichen oder vollständig entfernt wird.

Die Erfindung betrifft weiterhin Verfahren zum Herstellen von Suspensionen von anorganischen Partikeln eines piezoelektrisch und pyroelektrisch aktiven bzw. aktivierbaren Oxids in derartigen Fluorpolymer-Lösungen sowie die Produkte dieser Verfahren. Die farblosen Fluorpolymerlösungen bzw. opak-weißen Suspensionen sind für die Herstellung flächiger piezo- und pyroelektrischer Schichten, insbesondere durch Rakel- oder Siebdruckverfahren, geeignet.

**Beschreibung**

Die vorliegende Erfindung betrifft eine homogene, fluorpolymerhaltige Lösung, deren Polymere in kristallinem Zustand piezo- und pyroelektrische Eigenschaften aufweisen können und in der zusätzlich ein partikelförmiges piezo- und pyroelektrisches anorganisches Material suspendiert vorliegen kann, sowie ein Verfahren zu ihrer Herstellung. Die Polymerlösung eignet sich zur großflächigen Herstellung von ggf. flexiblen, piezo- und pyroelektrischen Schichten über Rakel- oder Siebdruckverfahren.

Piezo- und pyroelektrische Materialien verknüpfen Deformationen bzw. Temperaturänderungen mit Änderungen der elektrischen Ladungsverteilung. Es sind anorganische piezo- und pyroelektrische Keramiken und Einkristalle sowie organische Polymere bekannt, darunter z. B. Rohrzucker und — vor allem — Fluorpolymere. Die Materialien, deren einzelne Kristallite jeweils schon piezo- und pyroelektrisch sein können, erhalten ihre entsprechenden makroskopischen Eigenschaften ggf. durch einen Polungsschritt, der die uneinheitliche Orientierung der Kristallite kompensiert. Letztere Materialien werden als ferroelektrisch bezeichnet. Anorganische Materialien weisen hohe piezo- und pyroelektrische Koeffizienten auf, haben jedoch den Nachteil hoher Sprödigkeit und hoher akustischer Impedanz. Anorganische piezo- und pyroelektrische Materialien können als kompakte Keramiken oder als Dünnschichten hergestellt werden.

Bauteile aus piezo- und pyroelektrischen Keramiken werden über Sinterprozesse hergestellt, die hohe Temperaturen erfordern. Die hohen Verarbeitungstemperaturen beschränken bei der Synthese von Dünnschichten die Auswahl von Substraten. Bei Verwendung spezieller Methoden wie beispielsweise des Sol-Gel-Verfahrens in Kombination mit Mikrowellen- oder Lasersinterung können die Temperaturen zwar gesenkt werden; um hinreichend gute Materialeigenschaften zu erzielen, müssen aber im Allgemeinen etwa 500°C erreicht werden.

Von einer Reihe von halogenierten Polymeren wie PVC (Polyvinylchlorid), PVF (Polyvinylfluorid) und insbesondere PVDF (Polyvinylidenfluorid) ist bekannt, dass sie in bestimmten kristallinen Konformationen piezoelektrische, pyroelektrische und meist auch ferroelektrische Eigenschaften besitzen. Solche Eigenschaften haben auch viele Copolymere dieser Materialien, z.B. P(VDF/TFE) (TFE steht für Tetrafluorethylen), P(VDF/HFP) (HFP steht für Hexafluorpropylen) P(VDF/TrFE) (TrFE steht für Trifluorethylen), P(VDF-CTFE) (CTFE steht für Chlortrifluorethylen) oder P(VDF/HFP/TFE). Der Zusatz insbesondere kleinerer Mengen von TrFE oder TFE und dergleichen zu PVDF begünstigt die direkte Kristallisation der Fluoropolymeren in die β-Phase aus der Schmelze. Diese Phase besitzt die genannten Eigenschaften. Auch ist bei Zusatz solcher Comonomere ein späteres Verstrecken der Folie nicht nötig, wie es bei PVDF-Homopolymeren der Fall ist.

Die piezo- und pyroelektrischen Polymere sind flexibel, besitzen eine für Impedanzanpassungen vorteilhafte geringe Dichte, haben aber vergleichsweise niedrige piezo- und pyroelektrische Koeffizienten, wobei diese Koeffizienten stark von der jeweils erzielbaren Kristallstruktur bzw. von dem Anteil an kristalliner Struktur im Polymer abhängen. Die piezoelektrischen Eigenschaften von PVDF sind allerdings immerhin mehr als zehnmal so hoch wie die von Quarz. Üblicherweise werden Bauteile aus organischen piezo- und pyroelektrischen Materialien aus Folien hergestellt. Erhöhte Temperaturen sind dabei nur soweit erforderlich, als das Material in Lösung gebracht und das Lösungsmittel ausschließend wieder entfernt werden muss.

Bereits in den 70er Jahren des vorigen Jahrhunderts wurde versucht, anorganische und organische piezo- und pyroelektrische Materialien und damit deren jeweils vorteilhaften Eigenschaften miteinander zu verknüpfen. Herstellungsverfahren, Messmethoden und Modelle zur Berechnung von Eigenschaftsprofilen wurden entwickelt, siehe Das-Gupta, D.K. (Hrsg.): Ferroelectric Polymers and Ceramic-Polymer Composites. Trans Tech Publications Ltd., Schweiz, 1994. Ein übliches Verfahren zur Herstellung von PVDF-PZT-Kompositen ist das Mischen der beiden Komponenten in einem Walzwerk oder die Zugabe der anorganischen Komponente in eine Polymerlösung (siehe J. Zeng, Appl. Phys. 9 (2002), 2674-2679; Das-Gupta, a.a.O.; L. Linhua et al., Preparation of PCLT/P(VDF-TrFE) pyroelectric sensor based on plastic film substrate, Sensors and Actuators A 100 (2002) 231-235; EP 1769544 A1) und eine eventuelle Nachbehandlung durch Heißpressen.

Die Kombination eines ferroelektrischen Polymers mit einer ferroelektrischen Keramik eröffnet die Möglichkeit, Materialien herzustellen, die entweder nur piezo- oder nur pyroelektrisch sind. Durch ein spezielles Polungsverfahren können die Polarisationsrichtungen beider Komponenten parallel oder antiparallel eingestellt werden. Dadurch wird der piezo- oder pyroelektrische Effekt entweder kompensiert oder verstärkt (I. Graz et al., Flexible active-matrix cells with selectively poled bifunctional polymerceramic nanocomposite for pressure and temperature sensing skin, Journal of Applied Physics 106, 034503 (2009).

Für PVC, PVF und PVDF sowie deren Copolymere ist eine ganze Reihe von mehr oder weniger guten Lösungsmitteln bekannt. Dazu gehören cyclische Ether wie THF (Tetrahydrofuran) und GBL (γ-Butyrolacton; Dihydrofuran-2-on), aliphatische Ketone wie Aceton, Methylethylketon, 3-Pentanon oder 3-Hexanon, cyclische Ketone wie Cyclohexanon, Methylcyclohexanon oder Isophoron, halogenierte Kohlenwasserstoffe wie Trichlorethan oder Chlordifluormethan, Ester wie Propylencarbonat sowie Triethylphosphat, N-Methylpyrrolidon, Dimethylformamid und Dimethylsulfoxid. Das piezo- und pyroelektrische Material Polyvinylidenfluorid und dessen Copolymere lässt sich beispielsweise in Aceton, N-Methylpyrrolidon oder Dimethylformamid auflösen. Insgesamt ist bei einer Betrachtung der Löslichkeitseigenschaften solcher Fluorpolymere festzustellen, dass in der Regel diejenigen Lösungsmittel, die einen relativ niedrigen Siedepunkt und entsprechend einen relativ hohen Dampfdruck aufweisen, bessere Lösungsmittel als die höhersiedenden / weniger flüchtigen sind. Für die Verwendung einer Polymerlösung in einer Rakel- und insbesondere in einer Siebdruckanlage sollte das Lösungsmittel jedoch einen niedrigen Dampfdruck bzw. einen relativ hohen Siedepunkt aufweisen, damit es nicht vor der Zeit aus der zu rakelnden / zu druckenden Lösung abdampft und damit deren rheologische Eigenschaften bzw. die Gelöstheit des Polymer negativ beeinflusst. Außerdem ist es natürlich wünschenswert, mit möglichst wenig toxischen Lösungsmitteln zu arbeiten, da Druckprozesse meist an größeren Substraten, z.B. von der Rolle, verarbeitet werden und die entsprechenden Hallen zwar Absaugungen aufweisen, aber natürlich gegebenenfalls erforderliche Arbeitsschutzmaßnahmen im Großraum wesentlich schwerer zu realisieren sind als in kleinen, verschließbaren Anlagen. Daher ist bisher kein Lösungsmittel aufgefunden worden, das gleichzeitig die erforderliche Löslichkeit für das entsprechende Fluorpolymer, einen sehr geringen Dampfdruck und eine geringe Toxizität aufweist.

Man hat sich daher damit begnügen müssen, mit relativ schlecht lösenden Lösungsmitteln zu arbeiten. GBL beispielsweise hat einen relativ niedrigen Dampfdruck (0,4 hPa bei 20°C) und einen Siedepunkt von 204-206°C und ist außerdem nicht toxisch. Deshalb hat man seine Eigenschaften als Lösungsmittel für PVDF und dessen Copolymere recht genau untersucht. Dabei stellte sich heraus, wie aus M. Zirkl et al., Ferroelectrics 353, 173-185 (2007) und M. Zirkl, Herstellung und Charakterisierung von ferroelektrischen Polymer-Dünnfilmen und ihre Anwendung in integrierten organischen Infrarotsensoren, Univ.-Diss. Graz, Österreich, 2007 bekannt, dass P(VDF-TrFE) in GBL bei erhöhter Temperatur (180°C) bis zu einem gewissen Grad löslich ist. Die beschriebene Methode hat jedoch den Nachteil, dass beim Zusammengeben des Fluorpolymeren und GBL eine sehr zähe Mischung entsteht, die sich kaum rühren lässt, so dass eine Homogenisierung sehr problematisch ist. Das Produkt ist daher meist zweiphasig und außerdem gelblich; selbst dann, wenn man die Phasen zur Lösung ineinander bringt, bleibt die gelbliche Färbung erhalten. Tazaki et al. beschreiben in J. Appl. Polym. Sci. 65(8), 1517-1524 (1997), dass sich PVDF bei 180°C u.a. in GBL auflösen lässt. Beim Abkühlen der GBL-Lösung entstand ein Gel, das beim Wiederaufwärmen thermoreversibel in ein Sol überging. Es bildete sich nach den Angaben der Autoren die Kristallstruktur vom $\gamma$-Typ (TTTGTTT -Konformation), die für die Zwecke der vorliegenden Erfindung nicht von Interesse ist, während in Cyclohexanon die $\beta$-Phase entstand und in Dimethylformamid gar keine Gelbildung erfolgte, die nach Angabe der Autoren durch die Kristallisation des Polymeren verursacht ist. Die Synthese einer Lösung definierter Konzentration und somit definierter Viskosität ist demnach zumindest für standardisierte Prozesse, wie man sie benötigt, erschwert.

Lösungsbasierte druckbare Kompositvorstufen werden in M. Dietze et al., Sensors and Actuators A 143 (2008) 329-334 beschrieben. Als Lösungsmittel wird hier jedoch Dimethylformamid, eine toxische Substanz, verwendet.

Aus der Literatur ist bekannt, dass es für das Lösen von Lacken ganz allgemein hilfreich sein kann, mehrere Lösungsmittel einzusetzen, wobei dasjenige Lösungsmittel, das den höchsten Siedepunkt besitzt, alle Ausgangsmaterialien in dem Lack am besten lösen können muss. Neben diesem "aktiven" oder "wahren" Lösungsmittel können Colösemittel ("latent solvents") eingesetzt werden, die nur in Gegenwart des aktiven Lösungsmittels wirksam sind, siehe z.B. "Paints, Coatings, and solvents" von Dieter Stoye und Werner Freitag (Hrsg.), Wiley-VHC Verlag GmbH Weinheim/ Deutschland 1998, Second completely revised edition (Reprint 2001). Ein niedrig siedendes Lösungsmittel, z.B. Aceton, wird auch häufig als Hilfsmittel bei der Herstellung einer Polymer-Dispersion eingesetzt, wobei die Ausgangskomponenten darin gelöst werden und anschließend, nach dem Polymeraufbau, dieses Lösungsmittel durch ein Dispergiermittel, z.B. Wasser, ersetzt und durch Destillation entfernt wird, siehe z.B. EP 849 298 A1, worin die Herstellung einer Polyurethandispersion mit Hilfe dieser Methode beschrieben ist. In solchen Fällen wird das niedrig siedende Lösungsmittel aber nicht als Colösemittel eingesetzt. Für PVDF wurde der Einsatz eines Colösemittels ($CHClF_2$) bisher nur im Zusammenhang mit der Verwendung von überkritischem $CO_2$ beschrieben, siehe H.-S Byun et al., Korean J. Chem. Eng. 21 (6), 193-1198 (2204).

Aufgabe der vorliegenden Erfindung ist es, ein Verfahren bereitzustellen, mit dessen Hilfe man klare, homogene Lösungen von Fluorpolymeren in hochsiedenden Lösungsmitteln erhalten kann, die anschließend z.B. mit drucktechnischen Methoden in pyroelektrisch und piezoelektrisch aktive Schichten überführt werden können.

Gelöst wird die Aufgabe dadurch, dass das zu lösende Fluorpolymer, insbesondere PVDF oder ein Copolymer aus VDF und einem weiteren Fluormonomeren, in einem Gemisch aus mindestens zwei Lösungsmitteln gelöst wird, dessen erstes ein niedrigsiedendes Lösungsmittel (mit einem Siedepunkt von vorzugsweise unter 150°C, stärker bevorzugt unter 100°C und besonders bevorzugt unter 75°C und/oder einem Dampfdruck von vorzugsweise über 5 hPa, stärker bevorzugt über 25 hPa und noch stärker bevorzugt über 100 hPa bei 20°C) ist und dessen zweites ein hochsiedendes Lösungsmittel (mit einem Siedepunkt von vorzugsweise über 180°C und/oder einem Dampfdruck von unter 3, vorzugsweise von unter 1 hPa) ist. Die Differenz der Siedetemperatur zwischen dem ersten und dem zweiten Lösungsmittel sollte dabei vorzugsweise so gewählt werden, dass der Trennfaktor $\alpha \geq 1$ ist und vorzugsweise (um die Wirtschaftlichkeit des Verfahrens günstig zu gestalten) $\geq 1,04$ ist. Dieser Faktor errechnet sich unter der Voraussetzung nahezu idealen Verhaltens der Lösungsmittel nach

$$\log \alpha_{1,2} = \frac{T_{S2}^{*} - T_{S1}^{*}}{T_M} \cdot \left( 7,30 - 0,662 \cdot \log p_{tot} + \frac{T_M}{103 \cdot \log p_{tot}} \right)$$

$\alpha_{1,2}$    „relative Flüchtigkeit "oder" Trennfaktor"

$T_{S2}^{*}$    Siedepunkt schwer flüchtige Komponente

$T_{S1}^{*}$    Siedepunkt leicht flüchtige Komponente

$T_M$    Siedepunkt des Gemisches

$P_{tot}$    Druck im System bei der Destillation

Da Angaben für die Trennbarkeit über eine nur einfache Destillation aus der Literatur häufig nicht eindeutig zu entnehmen sind, kann als Faustregel gelten, dass in den meisten Fällen der Siedepunkt des hochsiedenden Lösungsmittels um mindestens 50°K höher liegen sollte als der des ersten Lösungsmittels. In bevorzugten Fällen liegt die Siedepunktdifferenz bei ≥60°K, stärker bevorzugt bei ≥70°K und ganz bevorzugt bei ≥80°K, weil dann eine Trennung bereits über eine einfache Destillation möglich ist. Wenn das Fluorpolymer vollständig gelöst ist, wird das erste Lösungsmittel im Wesentlichen oder vollständig entfernt. "Im Wesentlichen" soll in diesem Zusammenhang bedeuten, dass nicht mehr mehr als 5 Vol-%, stärker bevorzugt nicht mehr als 2 Vol.-% dieses Lösungsmittels im Gemisch verbleiben.

In einer bevorzugten Ausführungsform sind beide Lösungsmittel nur wenig oder nicht toxisch. Unter diesem Ausdruck soll zu verstehen sein, dass sie nicht als "sehr giftig", "giftig", "krebserzeugend", "erbgutverändernd",oder "reproduktionstoxisch (fortpflanzungsgefährdend)" im Sinne der deutschen Verordnung zum Schutz vor Gefahrstoffen (Gefahrstoffverordnung - GefStoffV) bzw. einer entsprechenden europäischen Verordnung (CLP-Verordnung (EG) Nr. 1272/2008) oder USamerikanischen Richtlinie in die Gefahrenklassen "Akute Toxizität Kategorie 1 bis 3", "Karzinogenität", "Keimzellmutagenität", oder "Reproduktionstoxizität" eingestuft sind und dann, wenn sie relativ hoch flüchtig sind, einen Arbeitsplatzgrenzwert nach der Verordnung "Technische Regeln für Gefahrstoffe" (TRGS 900) von mindestens 200 mg pro m³ und/oder — in allen Fällen - eine $LD_{50}$, gemessen an der Ratte, von nicht unter 200 mg/kg (GefStoffV) beziehungsweise 300mg/kg (CLP-Verordnung) aufweisen dürfen.

In einer davon unabhängigen bevorzugten Ausführungsform werden die mindestens zwei Lösungsmittel zuerst miteinander gemischt, und erst dann wird das Polymer, z.B. als Pulver oder in Granulatform, zugegeben.

Das zu lösende Fluorpolymer (z.B. PVDF oder ein Copolymer davon) wird demnach in Form eines Pulvers, eines Granulats oder dergleichen in mindestens zwei Lösungsmitteln gelöst, deren erstes ein niedrig siedendes gutes Lösungsmittel ist und deren zweites ein hoch siedendes, weniger gut lösendes Lösungsmittel ist. Vorzugsweise geschieht dies dadurch, dass das Fluorpolymer in eine Mischung der genannten Lösungsmittel eingebracht wird. Durch anschließendes Rühren entsteht eine klare homogene Lösung. Das Rühren erfolgt dabei vorzugsweise bei relativ milden Temperaturen, z.B. in günstiger Weise bei Raumtemperatur oder bis zu ca. 25°K darüber. Erfolgt die Herstellung dagegen bei Temperaturen in der Nähe des Schmelzpunktes des Polymers (der für PVDF bei 176°C und für ein Copolymer aus PVDF und TrFE im molaren Verhältnis von 70:30 bei 154,5°C liegt, kann dies die Reproduzierbarkeit der Herstellung bei manchen Mischungen in ungünstiger Weise beeinflussen. Anschließend wird das niedrig siedende Lösungsmittel bei möglichst nicht oder nur wenig erhöhter Temperatur (beispielsweise 40 °C) und ggf. Unterdruck aus dem Gemisch entfernt. Danach liegt eine klare homogene farblose Lösung vor, deren Viskosität über den Polymergehalt eingestellt werden kann.

Werden ausschließlich die genannten zwei Lösungsmittel eingesetzt, verwendet man diese vorzugsweise im Verhältnis von zwischen 80:20 und 20:80 (Vol./Vol.), stärker bevorzugt im Verhältnis von zwischen 65:35 und 35:65 (Vol./Vol). und ganz besonders bevorzugt im Verhältnis von zwischen 45:55 und 55:45 (Vol./Vol.). Man kann sie beispielsweise im Verhältnis von 1:1 (Vol./Vol.) einsetzen.

Als niedrig siedendes gutes Lösungsmittel (als Colöser) eignen sich z.B. Aceton mit einem Sdp. von 56°C, Tetrahydrofuran mit einem Sdp. v. 66°C und Trichlorethan mit einem Siedepunkt von 74°C. Aceton ist darunter aus Gründen des Gesundheitsschutzes besonders bevorzugt.

Als hoch siedendes, intermediäres Lösungsmittel kann beispielsweise DMSO (Sdp. 189°C), Triethylphosphat (Sdp- 215°C), γ-Butyrolacton, N-Methylpyrrolidin (Sdp. 203°C), ein cyclisches Keton wie Cyclohexanon (Sdp. 156°C), Cyclopentanon (Sdp. 131°C, Dampfdruck 11 hPa), 3-Methylcyclohexanon (Sdp. 162-163°C) oder Menthon-trans-2-isopropyl-5-methylcyclohexanon oder eine Mischung von zweien oder mehr dieser Lösungsmittel eingesetzt werden.

Erfindungsgemäße Polymerlösungen, die ausschließlich aus Polymer und einem hochsiedenden Lösungsmittel, insbesondere γ-Butyrolacton, bestehen, sind klar und farblos. Lösungen, die unter Temperatureinwirkung hergestellt werden, zeigen hingegen eine charakteristische gelblich-grüne Färbung. Gefärbte Lösungen sollen erfindungsgemäß vermieden werden, weil sich herausgestellt hat, dass sie für die Herstellung flächiger Schichten, insbesondere durch Rakel- und Siebdruckverfahren, ungeeignet sind bzw. zu schlechteren Produkten führen.

Es ist möglich, eine erfindungsgemäße Lösung herzustellen, die zusätzlich anorganische Partikel eines piezoelektrisch und pyroelektrisch aktiven bzw. aktivierbaren Oxids (einer Oxidkeramik) enthält. Beispiele sind PZT (Blei-Zirkonat-Titanat), BTO (Bariumtitanat), PTO (Bleititanat) und BNT-BT (Bismutnatriumtitanat-Bariumtitanat). Hierfür wird zunächst eine Suspension der anorganischen Partikel in einem geeigneten, vorzugsweise niedrig siedenden Suspensionsmittel hergestellt, ggf. unter Verwendung eines üblichen Dispergierhilfsmittels. Die Wahl des Suspensionsmittels ist an sich nicht kritisch; es ist jedoch darauf zu achten, dass die Partikel gut dispergiert werden können (beispielsweise mittels Ultraschall). Zusätzlich muss das Suspensionsmittel mit der PVDF bzw. PVDF-Kopolymer-Lösung kompatibel sein, das heißt es darf nicht zu einer Ausfällung des Polymers kommen. Geeignete Lösungsmittel hierfür sind z.B. aliphatische Ketone wie Aceton oder Methylethylketon (worunter Methylethylketon bevorzugt ist) oder manche Alkohole (Ethanol lässt sich in einer Menge von bis zu etwa 1:1 (Gew./Gew.) mit einer Lösung des fluorierten Polymer in GBL mischen). Die Partikelsuspension kann entweder dem Zwischenprodukt, d.h. der aus Polymer und Lösungsmittelgemisch bestehenden Lösung, oder der Polymerlösung zugesetzt werden, aus der das niedersiedende Lösungsmittel bereits entfernt wurde. Die im letzteren Fall entstehende Suspension besitzt in der Regel eine niedrige Viskosität, die durch zusätzliche Zugabe eines niedrig siedenden Lösungsmittels (insbesondere eines der oben für die erfindungsgemäße Herstellung erwähnten) ggf. weiter verringert werden kann, so dass ein Dispergieren der Partikel in der Polymerlösung mit geeigneten Methoden sehr gut durchgeführt werden kann (beispielsweise durch Ultraschallbehandlung). Anschließend wird der Anteil an Suspensionsmitteln und ggf. an niedrig siedendem Lösungsmittel wie oben beschrieben entfernt. Dadurch steigt die Viskosität der Lösung wieder an, so dass die Sedimentation der Partikel gehemmt wird. Für diesen Arbeitsschritt ist eine kurze Zeitdauer vorteilhaft, um die Dispersion der Partikel zu erhalten.

Aus einer derartigen Lösung, die nachstehend auch als Kompositvorstufe bezeichnet wird, kann ein Kompositmaterial mit den oben beschriebenen Eigenschaften hergestellt werden.

Die erfindungsgemäße Polymerlösung und bzw. die erfindungsgemäße Kompositvorstufe können u.a. auf ein Substrat aufgeschleudert, gerakelt oder auf einem Siebdrucker verarbeitet werden. Zum Aushärten der Schicht durch Entfernen des Lösungsmittels ist eine thermische Nachbehandlung erforderlich (in der Regel bei etwa 90°C-110°C; die Dauer dieser Nachbehandlung ist nicht kritisch und liegt in der Regel bei 5 min bis 5h). Die resultierenden ferroelektrischen Schichten erhalten durch einen anschließenden Polungsschritt ihren piezo- und pyroelektrischen Eigenschaften.

Die Erfindung zeichnet sich dadurch aus, dass sich die Polymerlösung während der Herstellung mit einem Magnetrührer problemlos durchmischen lässt. Es entsteht eine klare, farblose, homogene Lösung, deren Viskosität durch den Polymergehalt eingestellt werden kann. Dadurch lassen sich unproblematisch große Mengen an homogenen Lösungen geeigneter Viskosität herstellen, die anschließend für Druckprozesse oder dergleichen eingesetzt werden können, weil sich ihre Fließeigenschaften während des Druckprozesses nicht durch vorzeitiges Abdampfen von Lösungsmittel verändern. Außerdem wird die Umwelt weniger durch Lösungsmitteldämpfe belastet. Insbesondere dann, wenn wenig toxische oder völlig unbedenkliche Lösungsmittel als intermediäres Lösungsmittel eingesetzt werden, ergeben sich zusätzliche Vorteile unter gesundheitlichen Aspekten für die mit den Druck- oder sonstigen Weiterverarbeitungsprozessen befassten Menschen. Ein weiterer Vorteil liegt darin, dass die Lösung des Polymers bei Raumtemperatur erreicht werden kann. Das aus dem Lösungsmittelgemisch entfernte Colösemittel kann rückgewonnen und für die erfindungsgemäße Herstellung wiederverwendet werden.

Bei der Verwendung von Colösern zur Herstellung von Polymerlösungen nach dem Stand der Technik wie oben erläutert verbleibt das Colösemittel im Allgemeinen im Gemisch. Aus den bisher bekannt gewordenen Untersuchungen zur Herstellung von P(VDF-TrFE)-Schichten für den Einsatz als Sensoren weiß man, dass es besonders vorteilhaft für dieses Polymer ist, ausschließlich γ-Butyrolacton als Lösungsmittel zu verwenden (siehe M. Zirkl und M. Zirkl et al., a.a.O.). Die Art des Lösungsmittels bzw. des Lösungsmittelgemisches beeinflusst die Dichte und die Kristallinität und damit die elektronischen Eigenschaften des nach dem Abdampfen des Lösungsmittels erhaltenen Feststoffs. Dabei gilt, dass leicht flüchtige Lösungsmittel die Dichte des Polymer verringern bzw. "Cavities" beim Verdampfen verursachen. Auch steigt die Kristallinität bei nur langsamer Verdampfung an, was ein weiterer Grund für die erfindungsgemäß vorgeschlagene Verwendung eines hochsiedenden Lösungsmittels ist. Die Entfernung des Colösemittels, z.B. des Acetons, aus dem Gemisch nach dem erfindungsgemäßen Verfahren ermöglicht somit z.B. die Herstellung von klaren, farblosen PVDF-Lösungen in reinem γ-Butyrolacton oder von sonstigen Fluorpolymeren in ausschließlich einem hochsiedenden Lösungsmittel. Mit solchen Lösungen lassen sich qualitativ wesentlich hochwertigere Fluorpolymerschichten (wie z. B. P(VDF-TrFE)-Schichten aus GBL) herstellen als aus dem Stand der Technik bekannt. Über druckbare Vorstufen für piezo-und pyroelektrische Kompositmaterialien wird beispielsweise in K.I. Arshak et al., Sensors and Actuators 79 (2000) 102-114, oder Y.H. Son et al., Integrated Ferroelectrics, 88 (2007) 44-50 berichtet. In beiden Fällen handelt es sich bei den Vorstufen jedoch um Partikelsuspensionen, für die ein Nachbehandlungsschritt bei hohen Temperaturen (laut Arshak et al. 170°C, d.h. oberhalb der Schmelztemperatur von PVDF:TrEF (70:30), s.o.) erforderlich sein kann. Resultierende piezo- und pyroelektrische Eigenschaften werden in keiner der beiden Veröffentlichungen beschrieben. Es sind jedoch aufgrund der schlechteren Homogenität der aufgebrachten Schichten im Vergleich zu solchen aus lösungsbasierten Materialien schlechtere Eigenschaftsprofile, insbesondere schlechtere elektronische Eigenschaften, zu erwarten.

Der Vorteil des erfindungsgemäßen Verfahrens besteht in der Verwendung eines in der Regel ungiftigeren Lösungsmittels, der Möglichkeit, Partikel ohne weitere Vorbehandlung einarbeiten zu können, und in den guten piezo- und pyroelektrischen Eigenschaften des resultierenden Materials. Zusätzlich ermöglicht das Verfahren die definierte Einstellung der Viskosität und damit die Anpassung an das Applikationsverfahren, da die Viskosität der Vorstufe hauptsächlich durch den Gehalt an Polymer und somit durch die Einwaage bestimmt wird.

Ausführungsbeipiel 1 (Polymerlösung)

- Vorlegen von 250 ml γ-Butyrolacton (GBL) und 250 ml Aceton in 1 L Einhalskolben
- ca. 1 min Rühren mit einem Magnetrührer
- Einwiegen von 61,9 g P(VDF-TrFE)-Granulat
- Zugeben des Granulats zum Lösungsmittelgemisch unter Rühren
- 24 h Rühren bei Raumtemperatur (Ergebnis: klare farblose Flüssigkeit)
- Abrotieren von Aceton aus Gemisch (Gesamtdauer ca. 5 h)
- bei 40 °C bei einem Druck zwischen 250 mbar und 2-3 mbar Ergebnis: klare, farblose Lösung mit einer Viskosität von etwa 25 Pa s (bei Raumtemperatur und einer Scherrate von 10 s$^{-1}$)

Ausführungsbeispiel 2 (Kompositvorstufe)

Herstellen der Partikel-Suspension:

- Suspendieren von beispielsweise 0,5g PbTiO$_3$ —Pulver in 50 ml Methylethylketon, Ultraschallbehandlung für 1 h,
- 1 h sedimentieren lassen,
- Abpipettieren von ca. 30 g Suspension
- Eintrocknen der Suspension, Bestimmen des Gewichts des Rückstands (Beispiel: 2,3g)
- Erneutes Suspendieren des PbTiO$_3$-Pulvers in Methylethylketon (Beispiel: 30 ml) durch Ultraschallbehandlung (1 h)

Herstellen der Kompositvorstufe:

- Zugabe der Suspension zu einer entsprechenden Menge (Beispiel: 30g) an Polymerlösung, hergestellt nach Ausführungsbeispiel 1
- Ultraschallbehandlung für 1 h
- Abziehen von Methylethylketon aus dem Gemisch (Rotationsverdampfer bei 40 °C)

Ergebnis: weiße opake Suspension mit einer Viskosität von etwa 25 Pa s bei Raumtemperatur und einer Scherrate von 10 s$^{-1}$

Vergleichsbeispiel

- Erhitzen von 25m1 GBL in einem Dreihalskolben auf 180°C unter Verwendung eines Rückflusskühlers.
- Einwiegen von 18 Gew.% PVDF:TrFE Granulat (5,076 g)
- Sukzessives Zugeben des Granulats zum Lösemittel unter Rühren mit einem Magnetrüher
- 2-3 h Rühren unter dem Rückflusskühler bei 180°C
- Abkühlen der Lösung auf < 100°C
- Abfüllen der Lösung und Abkühlen auf Raumtemperatur

Ergebnis: gelbliche Lösung mit einer Viskosität von beispielsweise etwa 40 Pa s (bei Raumtemperatur und einer Scherrate von 10 s$^{-1}$)

Die nach dem erfindungsgemäßen Verfahren synthetisierten Lösungen können zur Herstellung von Sensorschichten eingesetzt werden. Die hierfür gewählten Techniken sind nicht kritisch; beispielsweise können Rakel-, Druck- oder Nassbeschichtungsverfahren wie z.B. Schleudern, Tauchen oder Sprühen verwendet werden. Solche Sensoren können beispielsweise im Bereich Human Machine Interface, als sogenannte "elektronische Haut" und im Bereich der Überwachung von Gebäuden oder Anlagen verwendet werden. Nachstehend wird beispielhaft ein Druckverfahren beschrieben:

Die Lösung des Beispiels 1 wird unter Verwendung einer Siebdruckanlage üblicher Bauart, z.B. des halbautomatischen Siebdruckers EKRA X1 verdruckt. Für den Druckprozess wird ein Sieb aus Polyestergewebe mit einer Gewebefeinheit von 110-34 cm/DIN (110 Fäden pro cm bei einer Fadendicke von 34 $\mu$m) und ein Rakel aus Polyurethangummi, Shore-Härte 65 verwendet. Die Lösung wird als Druckfarbe aufgetragen. Nach dem Druck unter Verwendung üblicher Parameter erfolgt die Härtung der Schicht durch eine thermische Nachbehandlung bei einer Temperatur zwischen 90°C und 110°C für eine Dauer von 5 min bis 5 h.

Die Eigenschaften der Schicht wurden an einer Probe wie folgt gemessen:

- Remanente Polarisation:　　　　　5-8 $\mu$C/cm$^2$
- Pyroelektrischer Koeffizient (RT):　40 $\mu$C/m$^2$K
- Piezoelektrischer Koeffizient (d$_{33}$):　25 pC/N

**Patentansprüche**

1.　Verfahren zum Herstellen einer homogenen Lösung eines Fluorpolymeren, ausgewählt unter Fluor-Homo- und Copolymeren und Gemischen verschiedener Fluor-Homo- und/oder Copolymere, in einem hochsiedenden Lösungsmittel, worin

(a) das zu lösende Fluorpolymer in einer Mischung aus mindestens zwei Lösungsmitteln gelöst wird, dessen erstes einen Siedepunkt von unter 150°C, und/oder einen Dampfdruck von über 5 hPa (bei 20°C) aufweist und dessen zweites ein hochsiedendes Lösungsmittel ist, das einen um mindestens 50°K höheren Siedepunkt aufweist als das erste Lösungsmittel und/oder dessen Siedepunkt so gewählt ist, dass die Lösungsmittel-Mischung einen Trennfaktor $\alpha$ von ≥1, aufweist, und anschließend
(b) das erste Lösungsmittel aus dem Gemisch im Wesentlichen oder vollständig entfernt wird.

2.　Verfahren nach Anspruch 1, worin das erste Lösungsmittel einen Siedepunkt von unter 75°C und/oder einen Dampfdruck von über 100 hPa (bei 20°C) aufweist und das zweite Lösungsmittel einen Siedepunkt von über 180°C und/oder einen Dampfdruck von unter 3 hPa besitzt.

3.　Verfahren nach Anspruch 1 oder 2, **dadurch gekennzeichnet, dass** die mindestens zwei Lösungsmittel zuerst vermischt werden und das zu lösende Fluorpolymer in die Lösungsmittel-Mischung gegeben wird.

4.　Verfahren nach einem der voranstehenden Ansprüche, **dadurch gekennzeichnet, dass** das Fluorpolymer PVDF oder ein Copolymer von Vinylidenfluorid mit einem weiteren fluorhaltigen Monomeren ist.

5.　Verfahren nach einem der voranstehenden Ansprüche, **dadurch gekennzeichnet, dass** das erste Lösungsmittel Aceton ist und dass das zweite Lösungsmittel Butyrolacton ist.

6.　Verfahren zum Herstellen einer Suspension von anorganischen Partikeln eines piezoelektrisch und pyroelektrisch aktiven bzw. aktivierbaren Oxids in einer homogenen Lösung eines Fluorpolymeren, ausgewählt unter Fluor-Homo- und Copolymeren und Gemischen verschiedener Fluor-Homo- und/oder Copolymere, in einem hochsiedenden Lösungsmittel, umfassend die Schritte:

(a) Herstellen einer Suspension der anorganischen Partikel in einem Suspensionsmittel,
(b) Lösen des Fluorpolymeren in einer Mischung aus mindestens zwei Lösungsmitteln, dessen erstes einen Siedepunkt von unter 150°C, und/oder einen Dampfdruck von über 5 hPa (bei 20°C) aufweist und dessen zweites ein hochsiedendes Lösungsmittel ist, das einen um mindestens 50°K höheren Siedepunkt aufweist als das erste Lösungsmittel und/oder dessen Siedepunkt so gewählt ist, dass die Lösungsmittel-Mischung einen Trennfaktor $\alpha$ von ≥1, aufweist,
(c) Zugeben der Suspension der anorganischen Partikel zu der Lösung des Fluorpolymeren gemäß (b) und
(d) vollständiges oder im Wesentlichen erfolgendes Entfernen des ersten Lösungsmittels und des Suspensionsmittels.

7.　Verfahren zum Herstellen einer Suspension von anorganischen Partikeln eines piezoelektrisch und pyroelektrisch aktiven bzw. aktivierbaren Oxids in einer homogenen Lösung eines Fluorpolymeren, ausgewählt unter Fluor-Homo- und Copolymeren und Gemischen verschiedener Fluor-Homo- und/oder Copolymere, in einem hochsiedenden Lösungsmittel, umfassend die Schritte:

(a) Herstellen einer Suspension der anorganischen Partikel in einem Suspensionsmittel,
(b) Herstellen einer Fluorpolymer-Lösung wie in einem der Ansprüche 1 bis 7 beansprucht,
(c) Zugeben der Suspension der anorganischen Partikel zu der Lösung des Fluorpolymeren gemäß (b) und
(d) vollständiges oder im Wesentlichen erfolgendes Entfernen des Suspensionsmittels.

8. Verfahren nach Anspruch 6 oder Anspruch 7, **dadurch gekennzeichnet, dass** das Suspensionsmittel einen Siedepunkt von unter 120°C, vorzugsweise von unter 100°C aufweist.

9. Verfahren nach Anspruch 8, **dadurch gekennzeichnet, dass** das Suspensionsmittel ausgewählt ist unter aliphatischen Ketonen sowie Mischungen von aliphatischen Ketonen oder Mischungen eines oder mehrerer Lösungsmittel mit aliphatischen Ketonen.

10. Verfahren nach Anspruch 9, worin das Suspensionsmittel Methylethylketon ist.

11. Verfahren nach einem der Ansprüche 6 bis 10, **dadurch gekennzeichnet, dass** das Fluorpolymer PVDF oder ein Copolymer von Vinylidenfluorid mit einem weiteren fluorhaltigen Monomeren ist.

12. Verfahren nach Anspruch 6, worin das erste Lösungsmittel einen Siedepunkt von unter 75°C und/oder einen Dampfdruck von über 100 hPa (bei 20°C) aufweist und das zweite Lösungsmittel einen Siedepunkt von über 180°C und/oder einen Dampfdruck von unter 3 hPa besitzt.

13. Verfahren nach Anspruch 12, **dadurch gekennzeichnet, dass** das erste Lösungsmittel Aceton ist, das zweite Lösungsmittel Butyrolacton ist und des Suspensionsmittel ein aliphatisches Keton mit einem Siedepunkt von unter 120°C und vorzugsweise Methylethylketon ist.

14. Farblose homogene Lösung eines Fluorpolymeren, ausgewählt unter Fluor-Homo- und Copolymeren und Gemischen verschiedener Fluor-Homo-und/oder Copolymere, in einem hochsiedenden Lösungsmittel, erhältlich nach einem Verfahren gemäß einem der Ansprüche 1 bis 5.

15. Farblose Suspension von anorganischen Partikeln eines piezoelektrisch und pyroelektrisch aktiven bzw. aktivierbaren Oxids in einer homogenen Lösung eines Fluorpolymeren, ausgewählt unter Fluor-Homo- und Copolymeren und Gemischen verschiedener Fluor-Homo- und/oder Copolymere, in einem hochsiedenden Lösungsmittel, erhältlich nach einem Verfahren gemäß einem der Ansprüche 6 bis 13.

16. Verwendung einer Lösung oder Suspension nach einem der Ansprüche 14 oder 15 zum Herstellen einer piezo- und pyroelektrische Schicht.

17. Verwendung nach Anspruch 16, worin die piezo- und pyroelektrische Schicht durch Rakel- oder Siebdruckverfahren gebildet wird.

Europäisches Patentamt

European Patent Office

Office européen des brevets

## EUROPÄISCHER RECHERCHENBERICHT

Nummer der Anmeldung

EP 10 17 4424

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A,D | EP 1 769 544 A1 (FACHHOCHSCHULE KIEL [DE] ZYRUS BETEILIGUNGSGMBH & CO PA [DE]) 4. April 2007 (2007-04-04) * Ansprüche 1,9 * | 6-13, 15-17 | INV. C08J3/09 C08J3/11 C08J3/215 H01L37/02 H01L41/22 H01L41/26 |
| A | US 2008/182154 A1 (KIM TAE KYOUNG [KR] ET AL) 31. Juli 2008 (2008-07-31) * Seite 1, Absatz 17-18; Beispiele * | 1-5,14 | |
| A | US 2004/131862 A1 (SZMANDA CHARLES R [US] ET AL) 8. Juli 2004 (2004-07-08) * Seite 1, Absatz 5-6 * * Seite 3, Absätze 20,24-25 * | 1-5,14 | |
| A | ZENG R., KWOK K.W.,CHAN H.L.W.,CHOY C.L.: "Longitudinal and transverse piezoelectric coefficients of lead zirconate titanate/vinylidene fluoride-trifluoroethylene composites with different polarization states", JOURNAL OF APPLIED PHYSICS, Bd. 92, Nr. 5, 1. September 2002 (2002-09-01), Seiten 2674-2679, XP002608513, * Seite 2674 * | 1-17 | |
| X,D | DIETZE ET AL: "Structural and functional properties of screen-printed PZT-PVDF-TrFE composites", SENSORS AND ACTUATORS A, ELSEVIER SEQUOIA S.A., LAUSANNE, CH, Bd. 143, Nr. 2, 22. November 2007 (2007-11-22), Seiten 329-334, XP022576755, ISSN: 0924-4247 * Seite 330 * | 14-16 | |

RECHERCHIERTE SACHGEBIETE (IPC)

C08J
H01L

-/--

Der vorliegende Recherchenbericht wurde für alle Patentansprüche erstellt

| Recherchenort | Abschlußdatum der Recherche | Prüfer |
|---|---|---|
| München | 10. Januar 2011 | Masson, Patrick |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

........................................................................

& : Mitglied der gleichen Patentfamilie, übereinstimmendes Dokument

EPO FORM 1503 03.82 (P04C03)

Europäisches
Patentamt

European
Patent Office

Office européen
des brevets

**EUROPÄISCHER RECHERCHENBERICHT**

Nummer der Anmeldung

EP 10 17 4424

| | EINSCHLÄGIGE DOKUMENTE | | |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (IPC) |
| A,D | JINHUA L.,NINGYI Y.,CHAN H.L.W.: "Preparation of PCLT/P(VDF-TrFE) pyroelectric sensor based on plastic film substrate", SENSORS AND ACTUATORS A, Bd. 100, 1. April 2002 (2002-04-01), Seiten 231-235, XP002608514, * Seite 231, rechte Spalte - Seite 232, linke Spalte * ----- | 1-17 | |
| A,D | ZIRKL M ET AL: "Synthesis of ferroelectric poly(vinylidene fluoride) copolymer films and their application in integrated full organic pyroelectric sensors", JOURNAL OF NANOSCIENCE AND NANOTECHNOLOGY, AMERICAN SCIENTIFIC PUBLISHERS, US, Bd. 353, 1. Januar 2007 (2007-01-01), Seiten 173-185, XP008093781, ISSN: 1533-4880 * Seite 175 * ----- | 1-17 | |
| A | TAZAKI MICHIKO; WADA RISEI; OKABE MASARU; HOMMA TERUTAKE: "Crystallization and gelation of poly(vinylidene fluoride) in organic solvents", JOURNAL OF APPLIED POLYMER SCIENCE, Bd. 65, 22. August 1997 (1997-08-22), Seiten 1517-1524, XP002608515, * das ganze Dokument * ----- | 1-17 | RECHERCHIERTE SACHGEBIETE (IPC) |
| A | DATABASE WPI Week 199904 Thomson Scientific, London, GB; AN 1999-040780 XP002608516, & JP 10 298298 A (KUREHA CHEM IND CO LTD) 10. November 1998 (1998-11-10) * Zusammenfassung * ----- | 1-17 | |

Der vorliegende Recherchenbericht wurde für alle Patentansprüche erstellt

| Recherchenort | Abschlußdatum der Recherche | Prüfer |
|---|---|---|
| München | 10. Januar 2011 | Masson, Patrick |

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 10 17 4424

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

10-01-2011

| Im Recherchenbericht angeführtes Patentdokument | | Datum der Veröffentlichung | Mitglied(er) der Patentfamilie | | | Datum der Veröffentlichung |
|---|---|---|---|---|---|---|
| EP 1769544 | A1 | 04-04-2007 | AT | 440386 | T | 15-09-2009 |
| | | | WO | 2006007830 | A1 | 26-01-2006 |
| | | | DE | 102004035386 | B3 | 08-09-2005 |
| US 2008182154 | A1 | 31-07-2008 | CN | 101235250 | A | 06-08-2008 |
| | | | JP | 2008184608 | A | 14-08-2008 |
| | | | KR | 100790426 | B1 | 03-01-2008 |
| US 2004131862 | A1 | 08-07-2004 | KEINE | | | |
| JP 10298298 | A | 10-11-1998 | JP | 3758297 | B2 | 22-03-2006 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1769544 A1

- EP 849298 A1

**In der Beschreibung aufgeführte Nicht-Patentliteratur**

- Ferroelectric Polymers and Ceramic-Polymer Composites. Trans Tech Publications Ltd, 1994
- **J. ZENG.** *Appl. Phys.,* 2002, vol. 9, 2674-2679
- **L. LINHUA et al.** Preparation of PCLT/P(VDF-TrFE) pyroelectric sensor based on plastic film substrate. *Sensors and Actuators A,* 2002, vol. 100, 231-235
- **I. GRAZ et al.** Flexible active-matrix cells with selectively poled bifunctional polymerceramic nanocomposite for pressure and temperature sensing skin. *Journal of Applied Physics,* 2009, vol. 106, 034503
- **M. ZIRKL et al.** *Ferroelectrics,* 2007, vol. 353, 173-185

- **M. ZIRKL.** Herstellung und Charakterisierung von ferroelektrischen Polymer-Dünnfilmen und ihre Anwendung in integrierten organischen Infrarotsensoren. *Univ.-Diss. Graz, Österreich,* 2007
- **TAZAKI et al.** *J. Appl. Polym. Sci.,* 1997, vol. 65 (8), 1517-1524
- **M. DIETZE et al.** *Sensors and Actuators A,* 2008, vol. 143, 329-334
- Paints, Coatings, and solvents. Wiley-VHC Verlag, 1998
- **H.-S BYUN et al.** *Korean J. Chem. Eng.,* vol. 21 (6), 193-1198
- **K.L. ARSHAK et al.** *Sensors and Actuators,* 2000, vol. 79, 102-114
- **Y.H. SON et al.** *Integrated Ferroelectrics,* 2007, vol. 88, 44-50